# EUROPEAN PATENT APPLICATION

(11) **EP 3 007 526 A1**
(43) Date of publication of application: **13.04.2016**
(21) Application number: 14188145.8
(22) Date of filing: 08.10.2014
(51) Int. Cl.: H05K 3/10, H05K 3/12, H05K 3/20

(54) **Manufacturing method and structure of circuit board with very fine conductive circuit lines**

(71) Applicant: T-Kingdom Co., Ltd., Zhongli City 320, Taoyuan (TW)
(72) Inventor: Tsai, Hsin Lun, 320 Taoyuan County (TW)
(74) Representative: Chaillot, Geneviève

(57) **Abstract**

A circuit board manufacturing method includes the steps of providing a conductive motherboard; forming a masking layer on the conductive motherboard, and the masking layer having a plurality of recessed portions that form a predetermined circuit pattern; forming a conductive electrode in each recessed portion, and the conductive electrodes together forming a conductive layer; providing a substrate having an adhesive layer provided thereon for sticking to a top of the masking layer and the conductive layer; and separating the substrate, the adhesive layer and the conductive layer from the conductive motherboard and the masking layer to provide a circuit board. The conductive motherboard is repeatedly usable and presents the predetermined circuit pattern through electroforming process, and the circuit pattern can be transferred to the substrate. The whole circuit board manufacturing process is simplified while ensures largely upgraded yield rate of very fine conductive circuit lines on the circuit board.

## Description

### FIELD OF THE INVENTION

The present invention relates to a method of fabricating patterned conductive circuit lines on a circuit board, and more particularly to a method of manufacturing a circuit board, on which very fine conductive circuit lines of 0.5µm∼20µm in width are formed.

### BACKGROUND OF THE INVENTION

Conventionally, the very fine conductive circuit lines on a flexible circuit board are fabricated through an etching process, which includes the steps of providing a carrier metal foil 10 having a metal oxide layer 11 formed on one surface thereof; plating a seed layer 12 on the metal oxide layer 11; forming a soft organic insulation material layer 13 on the seed layer 12; attaching a flexible backing layer 14 on the soft organic insulation material layer 13; peeling the carrier metal foil 10 off from an interface between the carrier metal foil 10 and the seed layer 12; and finally, forming a patterned circuit 15 on the seed layer 12.

To form the patterned circuit 15, the seed layer 12 is used as a seed to electroplate a circuit line forming metal layer 16; a patterned photoresist 17 is formed on the circuit line forming metal layer 16; the patterned photoresist 17 is used as a mask and the circuit line forming metal layer 16 and the seed layer 12 are etched to form the patterned circuit 15; and finally, the patterned photoresist 17 is removed from the circuit line forming metal layer 16.

The above-described wet etching produces an isotropic etching effect. Since the patterned photoresist 17 is an etch-resistant material, there is a relatively large difference between the etching rates of the etching fluid on the patterned photoresist 17 and on the circuit line forming metal layer 16. As a result, when the etching fluid etches in a vertical direction, a serious side etching will occur on the circuit line forming metal layer 16.

By using wet etching process to fabricate very fine conductive circuit lines, the total etched surface on the circuit line forming metal layer 16 would be too large in proportion to the total area thereof. The circuit line forming metal layer 16 is unevenly etched to result in increased electric impedance thereof. In some worse conditions, the fabricated conductive circuit lines will break locally. Therefore, the produced flexible circuit boards with the very fine conductive circuit lines are not easily controllable in quality and have low yield rate.

### SUMMARY OF THE INVENTION

A primary object of the present invention is to provide a manufacturing method of circuit board with very fine conductive circuit lines, in which a predetermined circuit pattern containing conductive circuit lines is formed on a conductive motherboard through electroforming, and the circuit pattern can be directly adhered to or indirectly transferred to a substrate for providing a circuit board. Therefore, the whole circuit board manufacturing process is simplified while ensures largely upgraded yield rate of the very fine conductive circuit lines on the circuit board.

Another object of the present invention is to provide a circuit board, on which a plurality of molded conductive electrodes is directly pressed against an adhesive layer, so that the contact areas between the conductive electrodes and the adhesive layer are increased to avoid separation of the conductive electrodes from the substrate in the manufacturing process and accordingly ensure upgraded yield rate.

To achieve the above and other objects, the manufacturing method according to a first embodiment of the present invention is to directly form conductive electrodes on a substrate, and the manufacturing method according to a second embodiment of the present invention is to first form conductive electrodes on a transfer carrier film and then transfer the conductive electrodes from the transfer carrier film to a substrate. The circuit board manufacturing method of the present invention is applied mainly to electronic circuit board production and touch sensing electrode design.

According to the first embodiment of the manufacturing method of the present invention, the following steps are included: providing a conductive motherboard; forming a masking layer on the conductive motherboard, and the masking layer being provided with a plurality of recessed portions that form a predetermined circuit pattern; forming a conductive electrode in each of the recessed portions on the masking layer, and the conductive electrodes together forming a conductive layer; providing a substrate, on one side of which an adhesive layer is provided for sticking to a top of the masking layer and the conductive layer; and separating the substrate, the adhesive layer and the conductive layer from the masking layer and the conductive motherboard to provide a circuit board, in which the conductive electrodes are very fine conductive circuit lines.

According to the second embodiment of the manufacturing method of the present invention, the following steps are included: providing a conductive motherboard; forming a masking layer on the conductive motherboard, and the masking layer being provided with a plurality of recessed portions that form a predetermined circuit pattern; forming a conductive electrode in each of the recessed portions on the masking layer, and the conductive electrodes together forming a conductive layer; providing a transfer carrier film and sticking the transfer carrier film to a top of the conductive layer and the masking layer; separating the transfer carrier film and the conductive layer from the masking layer and the conductive motherboard; providing a substrate, on one side of which an adhesive layer is provided for sticking to a top of the conductive layer; and separating the substrate, the adhesive layer and the conductive layer from the transfer carrier film to provide a circuit board, in which the conductive electrodes are very fine conductive circuit lines.

In both of the first and the second embodiment of the circuit board manufacturing method of the present invention, the conductive motherboard is subjected to a surface passivation treatment to form an easily separable surface, so as to reduce an adhesive strength between the conductive layer and the conductive motherboard to facilitate subsequent separation of the conductive layer from the conductive motherboard.

In an operable embodiment of the present invention, each of the conductive electrodes includes a conductive portion that fills up the recessed portion corresponding thereto and partially protrudes beyond the recessed portion.

In another operable embodiment of the present invention, each conductive electrode is formed in the recessed portion by sequentially forming a first functional portion, a conductive portion and a second functional portion in the recessed portion from bottom to top.

In a further operable embodiment of the present invention, the conductive motherboard has a plurality of cavities formed at positions corresponding to the recessed portions of the masking layer; and each conductive electrode is formed by first forming a first functional portion on inner wall surfaces of the cavity, then forming a conductive portion in the cavity and the recessed portion, and finally forming a second functional portion in the recessed portion. The first and second functional portions can be formed of a weatherproof material, a dulling material, a welding flux material or a darkening material.

In a still further operable embodiment of the present invention, each conductive electrode is formed by first forming a first functional portion on inner wall surfaces of the cavity, then forming a conductive portion in the cavity, and finally forming a second functional portion in the recessed portion.

To achieve the above and other objects, the circuit board structure according to the present invention includes a substrate, an adhesive layer, and a conductive layer. The adhesive layer is spread over one surface of the substrate. The conductive layer includes a plurality of conductive electrodes which are very fine conductive circuit lines and are arrayed to present a circuit pattern, and the circuit pattern is pressed against a surface of the adhesive layer, so that a part of every conductive electrode in the thickness direction is embedded in the surface of the adhesive layer to enable an increased contact area between the conductive electrode and the adhesive layer.

The adhesive layer is formed of a soft material that is deformable under pressure and will cure to form a rigid material after sticking to the conductive layer. And, the conductive electrodes of the conductive layer respectively have a width ranged between 0.5µm and 20µm.

In a preferred embodiment of the circuit board structure of the present invention, the conductive electrode includes a first part that is embedded in the adhesive layer, and a second part that is projected from the adhesive layer. The first part of the conductive electrode has a width larger than that of the second part.

Further, each of the conductive electrodes includes a conductive portion and at least one functional portion provided on a surface of the conductive portion. In an operable embodiment, each of the conductive electrodes includes two functional portions provided on a top and a bottom surface of the conductive portion, respectively. Alternatively, the two functional portions may cover outer surfaces of the conductive portion.

In view that the adhering strength is a very important factor that has influence on the yield rate of the very fine conductive circuit lines formed on the substrate of the circuit board, in the present invention, a circuit pattern containing conductive circuit lines is first formed on the surface of a molding conductive motherboard through an electroforming process, and the conductive motherboard and the patterned conductive circuit lines are directly adhered to a substrate or the patterned conductive circuit lines are transferred from a transfer carrier film to the substrate. By directly pressing the patterned conductive circuit lines against an adhesive layer spread over one surface of the substrate, the contact areas between the conductive electrodes, which are formed of the patterned conductive circuit lines, and the adhesive layer is increased to avoid separation of the conductive electrodes from the substrate in the manufacturing process and accordingly ensure upgraded yield rate. In addition, with the above arrangements, the whole circuit board manufacturing process is simplified while ensures largely upgraded yield rate of the very fine conductive circuit lines on the circuit board.

### BRIEF DESCRIPTION OF THE DRAWINGS

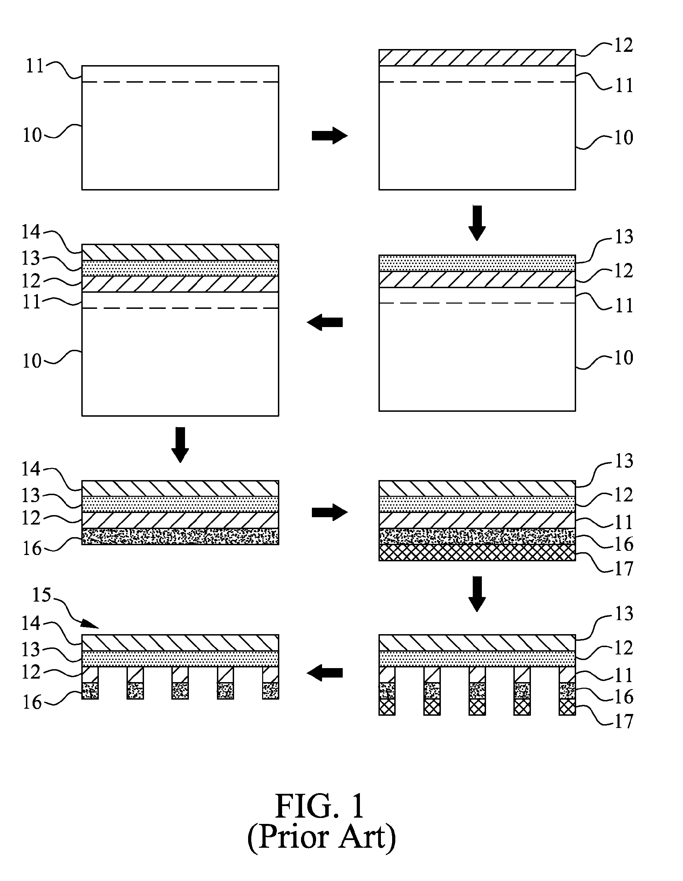

The structure and the technical means adopted by the present invention to achieve the above and other objects can be best understood by referring to the following detailed description of the preferred embodiments and the accompanying drawings, wherein
Fig. 1 is a pictorial description of the steps included in a conventional method of manufacturing a flexible circuit board;
Fig. 2 is a flowchart showing the steps included in a manufacturing method of circuit board according to a first embodiment of the present invention, in which a first type of conductive electrode is fabricated;
Fig. 3 is a pictorial description of the steps included in the manufacturing method of circuit board according to the first embodiment of the present invention;
Fig. 4 is a flowchart showing the steps included in a manufacturing method of circuit board according to a second embodiment of the present invention, in which the first type of conductive electrode is fabricated;
Fig. 5 is a pictorial description of the steps included in the manufacturing method of circuit board according to the second embodiment of the present invention;
Fig. 6 is a pictorial description of the steps for fabricating a second type of conductive electrode with the circuit board manufacturing method of the present invention;
Fig. 7 is a pictorial description of the steps for fabricating a third type of conductive electrode with the circuit board manufacturing method of the present invention;
Fig. 8 is a pictorial description of the steps for fabricating a fourth type of conductive electrode with the circuit board manufacturing method of the present invention;
Fig. 9 is a sectional view of a circuit board structure according to the present invention;
Figs. 10A to 10D are sectional views showing some different cross-sectional shapes available for the conductive circuit lines that form the conductive electrodes on the circuit board structure of the present invention; and
Figs. 11A to 11C are sectional views showing some different manners of forming functional portions on outer surfaces of the conductive circuit lines on the circuit board structure of the present invention.

### DETAILED DESCRIPTION OF THE PREFERRED EMBODIMENTS

The present invention will now be described with some preferred embodiments thereof and by referring to the accompanying drawings. For the purpose of easy to understand, elements that are the same in the preferred embodiments are denoted by the same reference numerals.

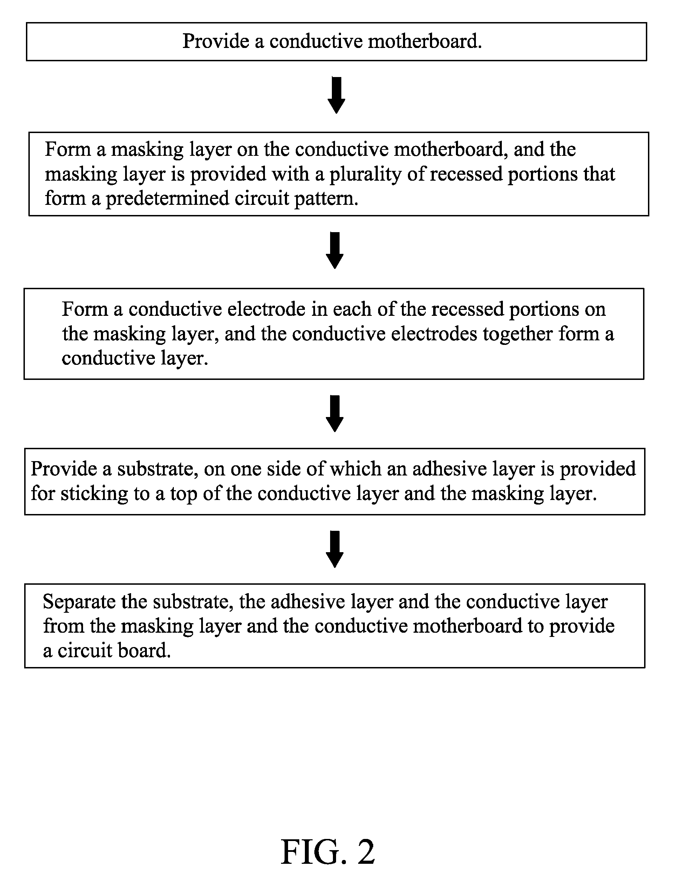

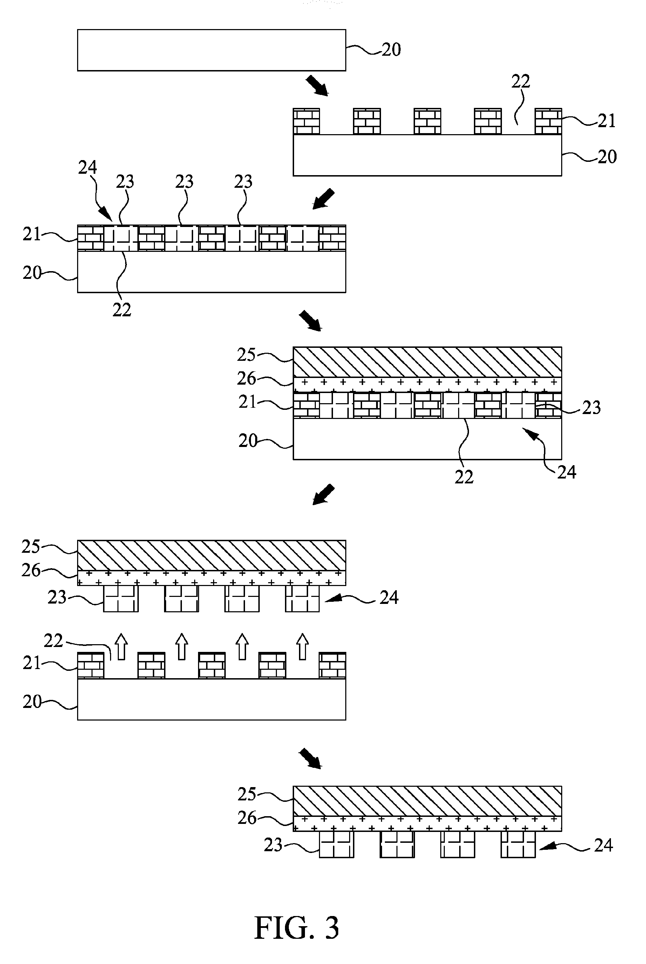

Please refer to Figs. 2 and 3 that are flowchart and pictorial description, respectively, showing the steps included in a manufacturing method of circuit board with very fine conductive circuit lines according to a first embodiment of the present invention. As shown, in a first step, a repeatedly usable conductive motherboard 20 made of a conductive material is provided. Then, in a second step, form a masking layer 21 on the conductive motherboard 20. The masking layer 21 is formed of an insulation material and is provided with a plurality of recessed portions 22, which form a predetermined circuit pattern. In a third step, form a plurality of conductive electrodes 23 in the recessed portions 22 on the masking layer 21, and the conductive electrodes 23 are very fine conductive circuit lines that together form a conductive layer 24.

In a fourth step, use a selected material to make a substrate 25, on one side of which an adhesive layer 26 is provided for directly sticking to a top of the masking layer 21 and the conductive layer 24 on the conductive motherboard 20. The adhesive layer 26 is formed of a soft material that is deformable under pressure and will cure to form a rigid material after sticking to the masking layer 21 and the conductive layer 24. Finally, in a fifth step, separate the substrate 25, the adhesive layer 26 and the conductive electrodes 23 from the conductive motherboard 20 and the masking layer 21 to provide a circuit board having a patterned circuit formed thereon.

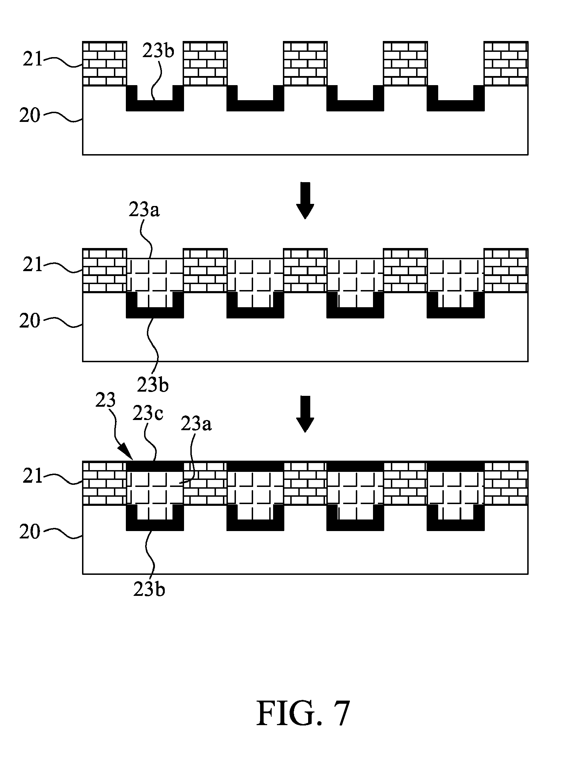

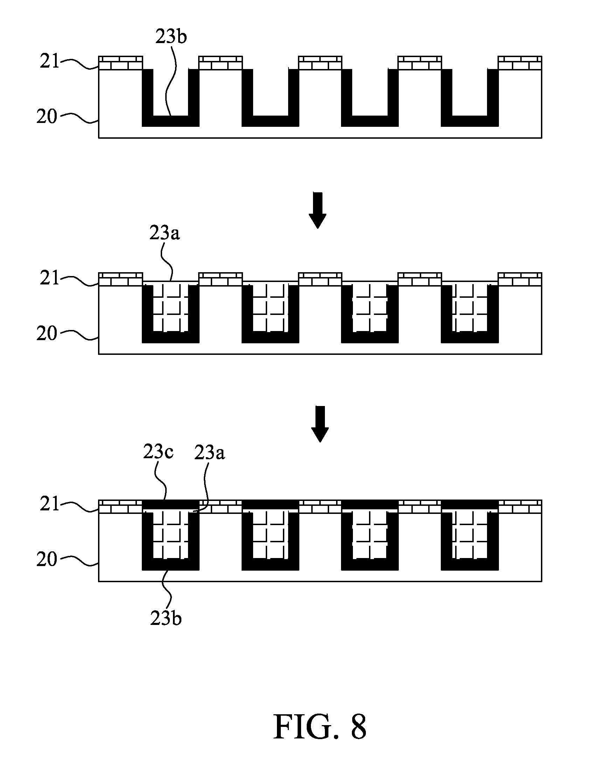

The conductive motherboard 20 may be first subjected to a surface passivation treatment to thereby have an easily separable surface to reduce its adhesive strength to the conductive layer 24 and enable ease of separation of the conductive motherboard 20 from the conductive layer 24 in the fifth step. Further, the conductive motherboard 20 may have a plurality of cavities 27 formed at positions corresponding to the aforesaid recessed portions 22 of the masking layer 21, as that shown in Figs. 7 and 8, so as to form different types of conduction electrodes 23.

The masking layer 21 is formed by way of printing or photolithography or a combination thereof. The conductive layer 24 can be formed by electroplating of gold, copper, silver, nickel, tin or any alloy thereof on the masking layer 21.

The substrate 25 can be formed of a soft material, a rigid material, a glass sheet, a polymeric material, or a ceramic material. The soft material for forming the substrate 25 can be polyethylene terephthalate (PET), poly(methyl methacrylate) (PMMA), polycarbonate (PC), poly(phenylene sulfone) (PPSU), polyethylenimine (PEI) or polyimide (PI).

After being separated from the conductive layer 24, the substrate 25 and the adhesive layer 26, the conductive motherboard 20 and the masking layer 21 are repeatedly usable for forming another conductive layer 24 thereon. Then, another piece of substrate 25 is attached to the conductive layer 24 via an adhesive layer 26. Finally, separate the conductive motherboard 20 and the masking layer 21 from the conductive layer 24. In this way, the circuit board manufacturing method is largely simplified to facilitate the production of circuit boards.

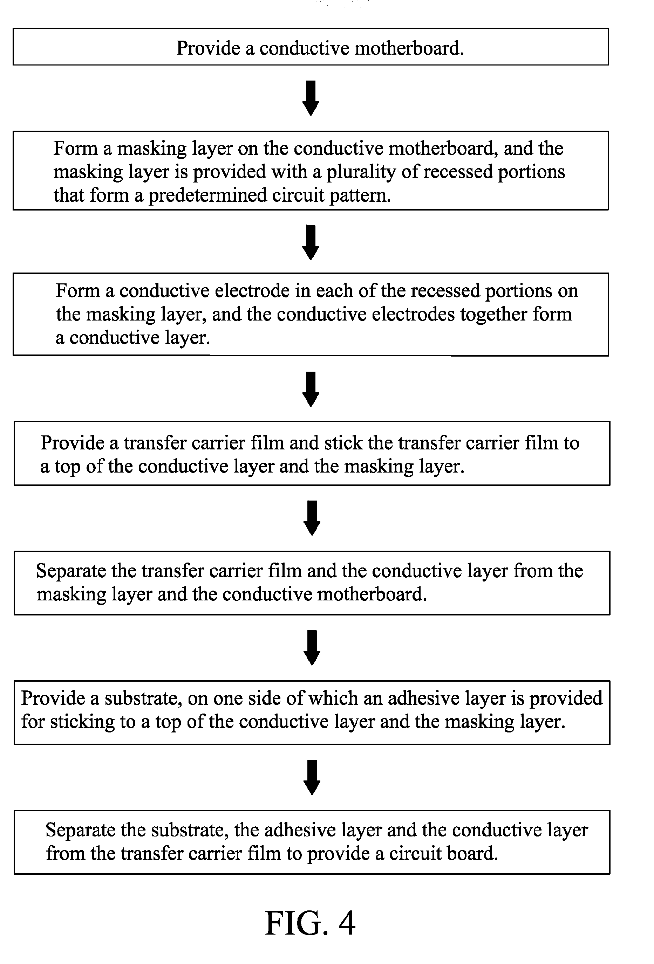

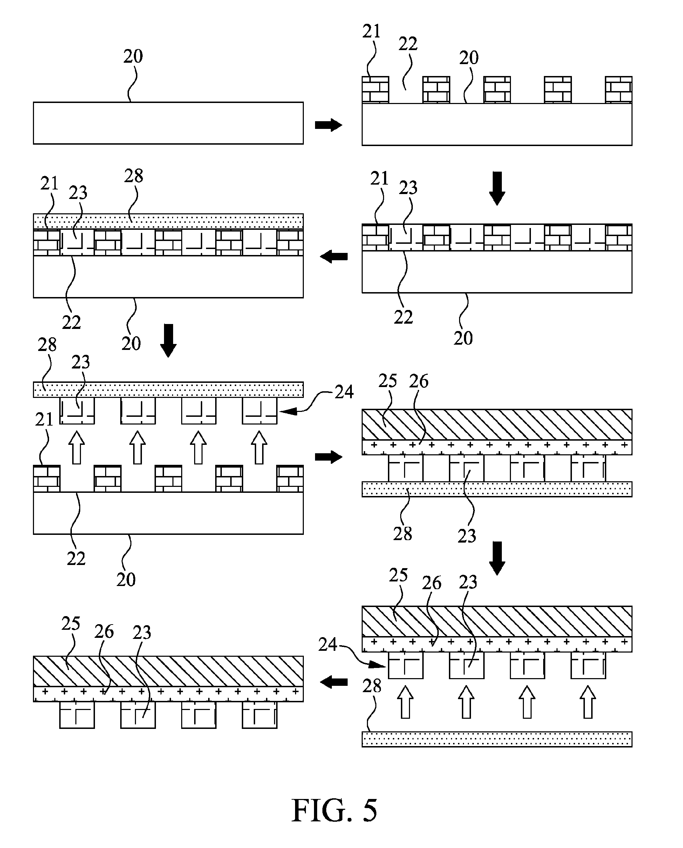

Figs. 4 and 5 are flowchart and pictorial description, respectively, showing the steps included in a manufacturing method of circuit board with very fine conductive circuit lines according to a second embodiment of the present invention. In the second embodiment, again, a repeatedly usable conductive motherboard 20 made of a conductive material is provided; then, form a masking layer 21 on the conductive motherboard 20, and the masking layer 21 is formed of an insulating material and provided with a plurality of recessed portions 22, which form a predetermined circuit pattern; and then, form a plurality of conductive electrodes 23 in the recessed portions 22 on the masking layer 21, and the conductive electrodes 23 are very fine conductive circuit lines that together form a conductive layer 24.

Thereafter, a transfer carrier film 28, which is a transitional structure in the manufacturing method of the present invention, is adhered to a top of the conductive layer 24 and the masking layer 21. Then, separate the transfer carrier film 28 and the conductive layer 24 from the surfaces of the masking layer 21 and the conductive motherboard 20. Then, provide a substrate 25 having an adhesive layer 26 provided on one side thereof for sticking to one side of the conductive layer 24 opposite to the transfer carrier film 28. Finally, separate the substrate 25, the adhesive layer 26 and the conductive layer 24 from the transfer carrier film 28 to provide a circuit board. That is, in the second embodiment, the final circuit board is not obtained by directly separating it from the conductive motherboard 20, but is obtained by separating it from the transitional structure of the transfer carrier film 28.

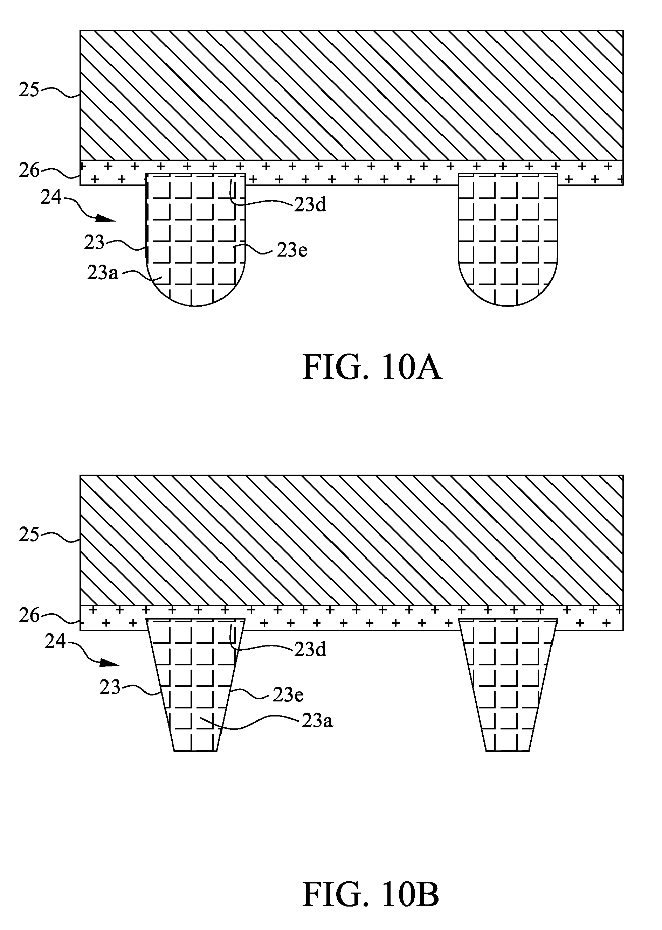

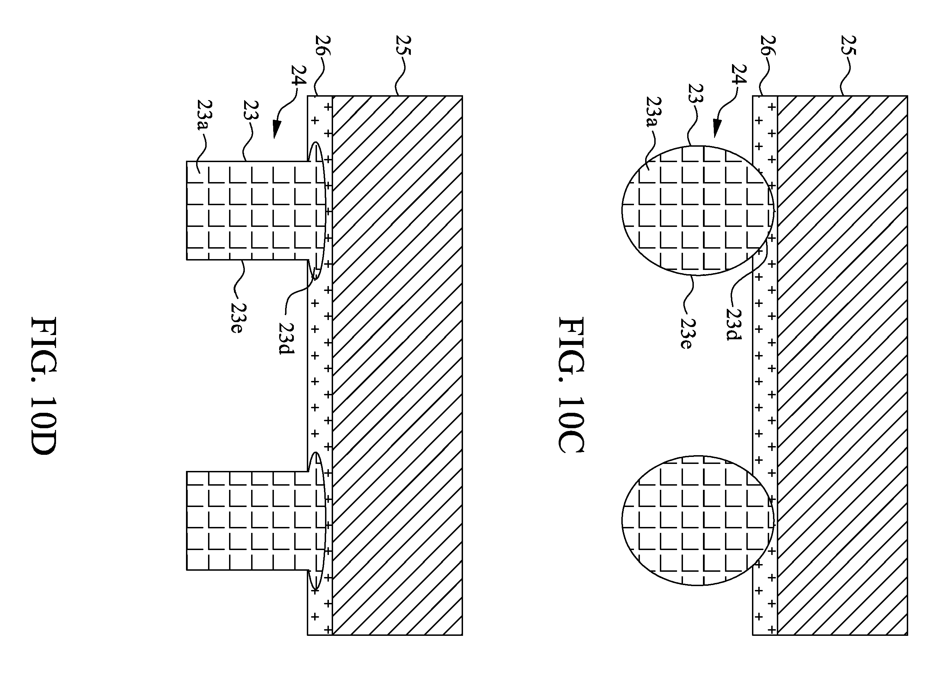

In either of the above two embodiments of the circuit board manufacturing method according to the present invention, the conductive electrodes 23 can be differently formed according to actual needs in use. First, as shown in Fig. 5 and Fig. 10D, a first type of conductive electrodes 23 is formed with the circuit board manufacturing method of the present invention. Each of the first type conductive electrode 23 includes a single conductive portion 23a (see Fig. 10D) that fills up the corresponding recessed portion 22. Alternatively, in another operable embodiment, the conductive portion 23a not only fills up the recessed portion 22, but also partially protrudes beyond the recessed portion 22 to thereby have a spherical head, as the conductive electrodes 23 shown in Fig. 10D.

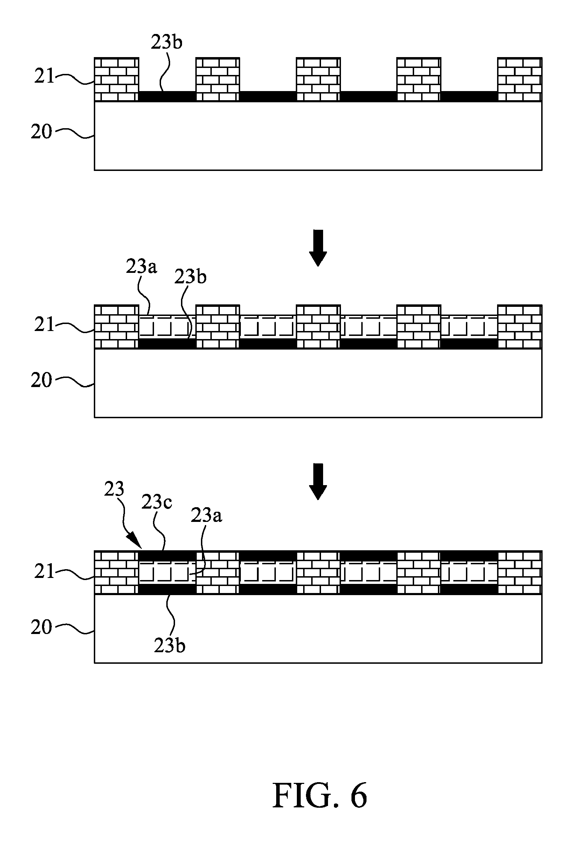

Please refer to Fig. 6, which shows the fabrication of a second type of conductive electrode 23 with the circuit board manufacturing method of the present invention. As shown, in the second type, the conductive electrode 23 is formed in the recessed portion 22 through three processing procedures, so that a first functional portion 23b, a conductive portion 23a and a second functional portion 23c are sequentially formed in the recessed portion 22 from bottom to top. The first and the second functional portion 23b, 23c are two horizontal layers sandwiching the conductive portion 23a between them. Alternatively, while not shown, the conductive electrode 23 can be formed in the recessed portion 22 through only two processing procedures, so that only the conductive portion 23a and the second functional portion 23c are sequentially formed in the recessed portion 22 from bottom to top.

Fig. 7 shows the fabrication of a third type of conductive electrode 23 with the circuit board manufacturing method of the present invention. As shown, for forming the third type conductive electrode 23, the conductive motherboard 20 is previously provided at positions corresponding to the recessed portions 22 with a cavity 27 each. The cavities 27 respectively have a depth smaller than that of the recessed portions 22. Then, in a first processing procedure, the inner wall surfaces of each cavity 27 are processed to form a first functional portion 23b. Thereafter, in a second processing procedure, a conductive portion 23a is formed in each cavity 27 and its corresponding recessed portion 22. Finally, in a third processing procedure, a second functional portion 23c is formed in each recessed portion 22. Each pair of the first and second functional portions 23b, 23c and the conductive portion 23a sandwiched between them together constitute one conductive electrode 23. As shown in Fig. 7, the first functional portion 23b located at the bottom of the conductive electrode 23 has a U-shaped cross section, while the second functional portion 23c located at the top of the conductive electrode 23 has a horizontally extended flat-shaped cross section.

Fig. 8 shows the fabrication of a fourth type of conductive electrode 23 with the circuit board manufacturing method of the present invention. As shown, for forming the fourth type conductive electrode 23, the conductive motherboard 20 is also previously provided at positions corresponding to the recessed portions 22 with a cavity 27 each. However, in the fourth type, the cavities 27 respectively have a depth larger than that of the recessed portions 22. Then, in a first processing procedure, the inner wall surfaces of each cavity 27 are processed to form a first functional portion 23b. Thereafter, in a second processing procedure, a conductive portion 23a is formed in each cavity 27 and a lower part of its corresponding recessed portion 22, such that the conductive portion 23a has a large area being covered by the first functional portion 23b. Finally, in a third processing procedure, a second functional portion 23c is formed in each recessed portion 22. Each pair of the first and second functional portions 23b, 23c and the conductive portion 23a sandwiched between them together constitute one conductive electrode 23. As shown in Fig. 8, the completed conductive electrode 23 is enclosed in the first and the second functional portion 23b, 23c with only a very small part of the conductive portion 23a exposed to an external environment.

The above second, third and fourth types of conductive electrodes 23 all have a multilayer complex structure, in which the first and second functional portions 23b, 23c can be formed of a weatherproof material, a dulling material, a welding flux material or a darkening material, depending on actual need in use. Further, the first and second functional portions 23b, 23c respectively have a thickness ranged between 1 nanometer (nm) and 1000 nm.

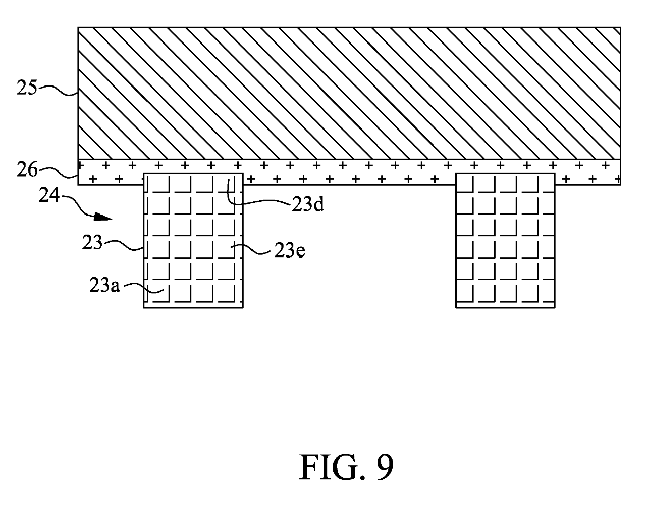

The present invention also provides a circuit board structure. Fig. 9 is a sectional view of the circuit board structure according to the present invention. As shown, the circuit board structure includes a substrate 25, an adhesive layer 26 and a conductive layer 24. The adhesive layer 26 is spread over one surface of the substrate 25. The conductive layer 24 includes a plurality of conductive electrodes 23, which are very fine conductive circuit lines being arrayed to present a circuit pattern, and the circuit pattern is pressed against the surface of the adhesive layer 26, so that a part of every conductive electrode 23 in the thickness direction is embedded in the surface of the adhesive layer 26, enabling an increased contact area between the conductive electrode 23 and the adhesive layer 26.

The adhesive layer 26 is formed of a soft material that is deformable under pressure and will cure to form a rigid material after sticking to the conductive layer 24. The conductive electrodes 23 of the conductive layer 24 respectively have a width ranged between 0.5µm and 20µm. The part of the conductive electrode 23 embedded in the adhesive layer 26 is defined as a first part 23d, and another part of the conductive electrode 23 projected from the adhesive layer 26 is defined as a second part 23e. In a preferred embodiment of the present invention, the first part 23d of the conductive electrode 23 has a width larger than that of the second part 23e.

The individual conductive electrode 23 shown in Fig. 9 has a conductive portion 23a, which has a substantially rectangular sectional shape and is formed of one single type of conductive material. However, it is understood the conductive portion 23a shown in Fig. 9 is only illustrative to facilitate easy explanation of the present invention and not intended to limit the present invention in any way. That is, the conductive portion 23a of the conductive electrode 23 can be differently shaped according to actual need in use. Figs. 10A to 10D illustrate some examples of the sectional shapes available for the conductive portion 23a of the conductive electrode 23. The conductive portions 23a of the conductive electrodes 23 shown in Figs. 10A to 10D are in a bullet sectional shape, a trapezoidal sectional shape, a round sectional shape and a rectangular sectional shape with a spherical head, respectively.

According to another operable embodiment of the present invention, the conductive electrode 23 can include a conductive portion 23a and at least a second functional portion 23c that is located at a top of the conductive portion 23a.

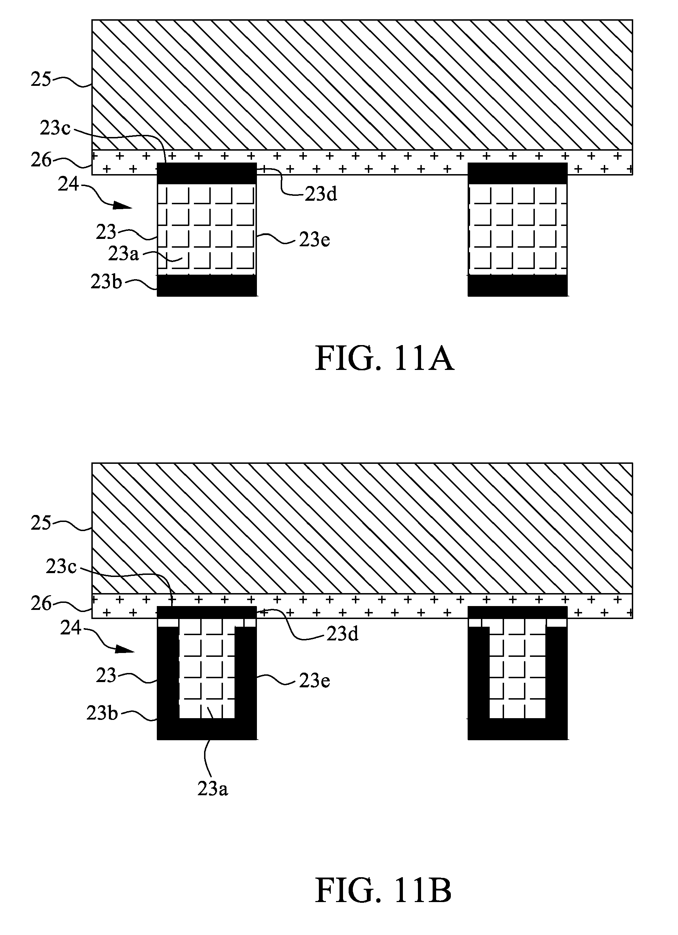

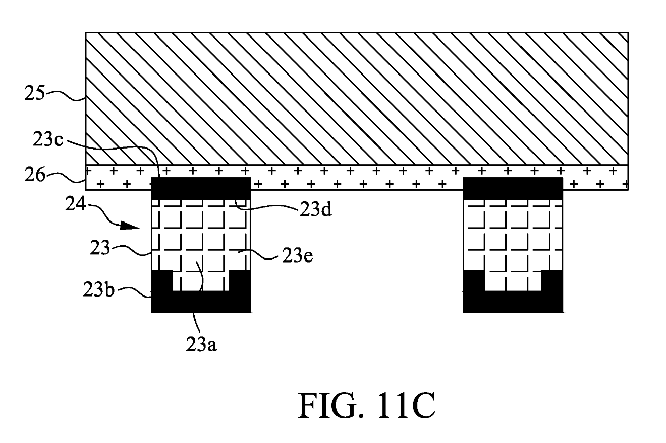

Please refer to Fig. 11A. Each conductive electrode 23 shown in Fig. 11A includes a first and a second functional portion 23b, 23c, which are horizontally located at a bottom and a top surface of the conductive portion 23a, respectively. In Figs. 11B and 11C, the second functional portion 23c is horizontally provided on the top surface of the conductive portion 23a, while the first functional portion 23b is provided on the bottom of the conductive portion 23a to have a U-shaped cross section. The U-shaped first functional portion 23b in Fig. 11B has a height larger than that of the U-shaped first function portion 23b in Fig. 11C.

The present invention has been described with some preferred embodiments thereof and it is understood that many changes and modifications in the described embodiments can be carried out without departing from the scope and the spirit of the invention that is intended to be limited only by the appended claims.

## Claims

1. A manufacturing method of circuit board with very fine conductive circuit lines, comprising the following steps:
providing a conductive motherboard;
forming a masking layer on the conductive motherboard, and the masking layer being provided with a plurality of recessed portions that form a predetermined circuit pattern;
forming a conductive electrode in each of the recessed portions on the masking layer, and the conductive electrodes being very fine conductive circuit lines that together form a conductive layer;
providing a substrate, on one side of which an adhesive layer is provided for sticking to a top of the masking layer and the conductive layer; and
separating the substrate, the adhesive layer and the conductive layer from the masking layer and the conductive motherboard to provide a circuit board.

2. The manufacturing method of circuit board with very fine conductive circuit lines as claimed in claim 1, wherein the conductive motherboard is subjected to a surface passivation treatment to form an easily separable surface.

3. The manufacturing method of circuit board with very fine conductive circuit lines as claimed in claim 1, wherein the conductive motherboard has a plurality of cavities formed at positions corresponding to the recessed portions of the masking layer.

4. The manufacturing method of circuit board with very fine conductive circuit lines as claimed in claim 3, wherein each conductive electrode is formed by first forming a first functional portion on inner wall surfaces of the cavity, and then forming a conductive portion in the cavity and the recessed portion, and finally forming a second functional portion in the recessed portion.

5. A manufacturing method of circuit board with very fine conductive circuit lines, comprising the following steps:
providing a conductive motherboard;
forming a masking layer on the conductive motherboard, and the masking layer being provided with a plurality of recessed portions that form a predetermined circuit pattern;
forming a conductive electrode in each of the recessed portions on the masking layer, and the conductive electrodes being very fine conductive circuit lines that together form a conductive layer;
providing a transfer carrier film and sticking the transfer carrier film to a top of the conductive layer and the masking layer;
separating the transfer carrier film and the conductive layer from the masking layer and the conductive motherboard;
providing a substrate, on one side of which an adhesive layer is provided for sticking to a top of the conductive layer; and
separating the substrate, the adhesive layer and the conductive layer from the transfer carrier film to provide a circuit board.

6. The manufacturing method of circuit board with very fine conductive circuit lines as claimed in claim 5, wherein the conductive motherboard is subjected to a surface passivation treatment to form an easily separable surface.

7. The manufacturing method of circuit board with very fine conductive circuit lines as claimed in claim 5, wherein the conductive motherboard has a plurality of cavities formed at positions corresponding to the recessed portions of the masking layer.

8. The manufacturing method of circuit board with very fine conductive circuit lines as claimed in claim 7, wherein each conductive electrode is formed by first forming a first functional portion on inner wall surfaces of the cavity, and then forming a conductive portion in the cavity and the recessed portion, and finally forming a second functional portion in the recessed portion.

9. A circuit board structure with very fine conductive circuit lines, comprising:
a substrate;
an adhesive layer being spread over one surface of the substrate; and
a conductive layer including a plurality of conductive electrodes, which are very fine circuit lines and are arrayed to present a circuit pattern, and the circuit pattern being pressed against a surface of the adhesive layer, so that a part of every conductive electrode in the thickness direction is embedded in the surface of the adhesive layer to enable an increased contact area between the conductive electrode and the adhesive layer.

10. The circuit board structure with very fine conductive circuit lines as claimed in claim 9, wherein the conductive electrode includes a first part that is embedded in the adhesive layer, and a second part that is projected from the adhesive layer; and the first part of the conductive electrode having a width larger than that of the second part.

11. The circuit board structure with very fine conductive circuit lines as claimed in claim 9, wherein each of the conductive electrodes includes a conductive portion and at least one functional portion provided on a surface of the conductive portion.

12. The circuit board structure with very fine conductive circuit lines as claimed in claim 11, wherein each of the conductive electrodes includes two functional portions provided on a top and a bottom surface of the conductive portion, respectively.

13. The circuit board structure with very fine conductive circuit lines as claimed in claim 11, wherein the at least one functional portion covers outer surfaces of the conductive portion.

14. The circuit board structure with very fine conductive circuit lines as claimed in claim 9, wherein the adhesive layer is formed of a soft material that is deformable under pressure and will cure to form a rigid material after sticking to the conductive layer.

15. The circuit board structure with very fine conductive circuit lines as claimed in claim 11, wherein the conductive electrodes of the conductive layer respectively have a width ranged between 0.5µm and 20µm.
